# EUROPÄISCHE PATENTANMELDUNG

(11) **EP 4 568 110 A1**
(43) Veröffentlichungstag der Anmeldung: **11.06.2025**
(21) Anmeldenummer: 24217502.4
(22) Anmeldetag: 04.12.2024
(51) Int. Cl.: H03K 17/082

(54) **DIAGNOSE ZUR ERKENNUNG DEFEKTER HALBLEITERSCHALTER FÜR DIE ERREGERSTROMSTELLUNG BEI EINER FREMDERREGTEN SYNCHRONMASCHINE**

(30) Priorität: 05.12.2023 DE 102023133974
(71) Anmelder: VOLKSWAGEN AG, 38440 Wolfsburg (DE); AUDI AG, 85057 Ingolstadt (DE)
(72) Erfinder: Gerth, Hendrik, 31275 Lehrte (DE); Graßl, Tobias, 85095 Denkendorf (DE)
(74) Vertreter: Obst, Bernhard

(57) **Zusammenfassung**

Die Erfindung betrifft ein Verfahren zum Erkennen eines einzelnen dauerhaft leitenden defekten Halbleiterschalters (210, 340) einer halbgesteuerten H-Brückenschaltung (100) zum Stellen eines Erregerstroms einer fremderregten Synchronmaschine, wobei mit der H-Brückenschaltung (100) eine Gesamtstrommesseinrichtung (180) verbunden ist, die den gesamten durch die H-Brückenschaltung (100) fließenden Strom I_{DC} misst;
wobei die halbgesteuerte H-Brückenschaltung (100) mit einer Steuereinrichtung (1200) gekoppelt ist, die zwei gleichfrequente, um eine halbe Periode phasenversetzte pulsweitenmodulierte Steuersignale (611, 621) zum Ansteuern der Halbleiterschalter (210, 340) erzeugt,
wobei das Verfahren die Schritte umfasst:
a) Verändern des Steuersignalmusters, sodass für mindestens eine zeitlich begrenzte Prüfzeitspanne ein Prüfschaltzustand entsteht, in dem der eine der Halbleiterschalter T1 (210) und der eine weitere der Halbleiterschalter T4 (340) zeitgleich offen sind,
b) Messen eines durch die halbgesteuerte H-Brückenschaltung (100) fließenden Prüfstroms während der Prüfzeitspanne,
c) Auswerten, ob der während der mindestens einen Prüfzeitspanne gemessene Prüfstrom negativ ist,
d) Erzeugen und Ausgeben eines Fehlersignals, wenn die Auswertung ergeben hat, dass der während der mindestens einen Prüfzeitspanne gemessenen Prüfstrom nicht negativ ist.

Die Erfindung betrifft ferner eine Steuereinrichtung und ein Computerprogrammprodukt, die das beschriebene Verfahren umsetzen.

## Beschreibung

Die Erfindung betrifft ein Verfahren zum Erkennen eines einzelnen dauerhaft leitenden, defekten Halbleiterschalters einer halbgesteuerten H-Brückenschaltung zum Stellen eines Erregerstroms einer fremderregten Synchronmaschine. Darüber hinaus betrifft die Erfindung eine Steuervorrichtung mit einer Detektionseinrichtung zum Erkennen eines einzelnen dauerhaft leitenden, defekten Halbleiterschalters einer solchen halbgesteuerten H-Brückenschaltung zum Stellen eines Erregerstroms.

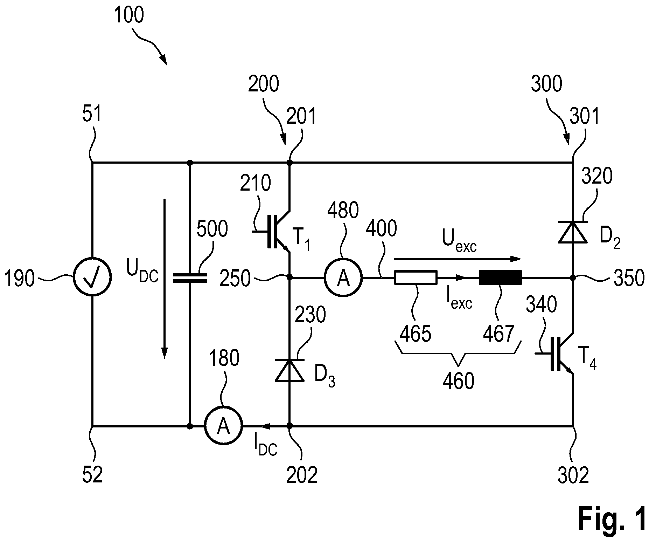

Als Ansteuerschaltung zur Erzeugung eines Erregerstroms einer fremderregten Synchronmaschine wird häufig eine halbgesteuerte H-Brückenschaltung verwendet, die kurz auch halbgesteuerte H-Brücke genannt wird. In Fig. 1 ist schematisch eine solche Schaltung dargestellt. Die Schaltung 100 umfasst einen Brückenzweig 200 und einen weiteren Brückenzweig 300. Der eine Brückenzweig 200 umfasst einen Halbleiterschalter 210, der auch mit dem Kürzel T1 bezeichnet wird. In Reihe mit dem Halbleiterschalter 210 ist eine in Sperrrichtung gepolte Diode 230 verschaltet, die auch als D3 bezeichnet wird. Der weitere Brückenzweig 300 umfasst eine in Sperrrichtung angeordnete weitere Diode 320, welche auch als D2 bezeichnet wird. In Reihe mit der weiteren Diode ist in dem weiteren Brückenzweig 300 ein weiterer Halbleiterschalter 340 angeordnet, der auch als T4 bezeichnet wird.

Zwischen einem Verbindungspunkt 250 des einen Brückenzweigs 200 zwischen dem einen Halbleiterschalter 210 und der einen Diode 230 und einem weiteren Verbindungspunkt 350 des weiteren Brückenzweigs 300 zwischen der weiteren Diode 320 und dem weiteren Halbleiterschalter 340 ist ein Lastzweig 400 ausgebildet. Der Lastzweig 400 umfasst eine Erregerwicklung 460, für die als Ersatzschaltbild ein ohmscher Wicklungswiderstand 465 und eine Wicklungsinduktivität 467 eingezeichnet sind. Im Lastzweig 400 ist ferner eine Strommesseinrichtung 480 in Reihe mit der Erregerwicklung 460 ausgebildet. Die Strommesseinrichtung 480 ist ausgebildet, den Erregerstrom I_{exc} zu messen. Über der Erregerwicklung 460 fällt eine Anregungsspannung U_{exc} ab. Der Brückenzweig 200 und der weitere Brückenzweig 300 sind mit einem Ende 201, 301 mit einem positiven Pol 51 einer Versorgungsspannung U_{DC} und mit dem gegenüberliegenden Ende 202, 302 mit einem Minuspol 52 der Versorgungsspannung verbunden. Parallel zu dem Brückenzweig 200 ist ein Zwischenkreiskondensator 500 angeordnet. An diesem liegt die Versorgungsspannung U_{DC} an. Zusätzlich ist eine Gesamtstrommesseinrichtung 180 ausgebildet, die den durch die halbgesteuerte Brückenschaltung 100 fließenden Gesamtstrom I_{DC} messen kann. Parallel zu dem Zwischenkreiskondensator 500 kann eine Spannungsmesseinrichtung 190 ausgebildet sein, die die Versorgungsspannung U_{DC} misst.

Um einen Erregerstrom I_{exc} gemäß einer Anforderung, beispielsweise eines Fahrers in einem Fahrzeug, das mit einer fremderregten Synchronmaschine angetrieben wird, zu bewirken, werden die Halbleiterschalter T1, T4; 210, 340 jeweils mit einem pulsweiten modulierten Steuersignal angesteuert. Wenn im Folgenden von den Halbleiterschaltern gesprochen wird, sind hierunter der eine Halbleiterschalter 210, T1 und der eine weitere Halbleiterschalter 340, T4 zu verstehen. Wenn von einem der Halbleiterschalter gesprochen wird, kann dies entweder der eine Halbleiterschalter 210, T1 oder der eine weitere Halbleiterschalter 340, T4 sein.

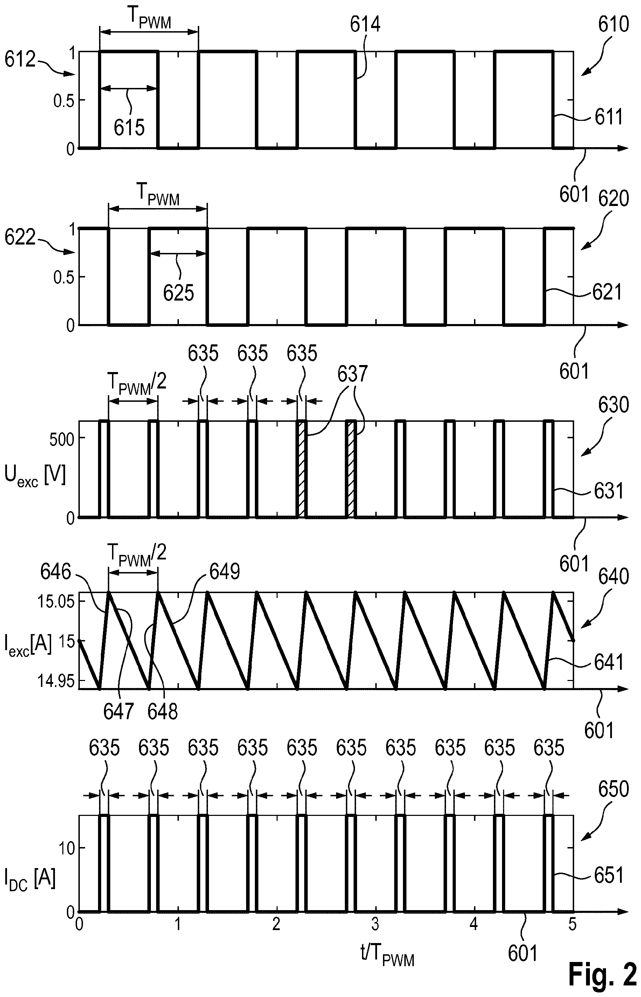

Die Steuersignale 611, 621 sind Rechtecksignale mit der gleichen Frequenz, die jedoch um eine halbe Periode T_{PWM} gegeneinander versetzt sind (siehe Fig. 2). Durch die halbgesteuerte Halbleiterbrücke fließt ein Strom, wenn sowohl der eine der Halbleiterschalter 210, T1 als auch zusätzlich zeitgleich der weitere der Halbleiterschalter 340, T4 leitend sind.

Die Steuersignale 611, 621 weisen jeweils das gleiche Tastverhältnis auf, welches 50 % oder größer ist. Als Tastverhältnis wird das Zeitverhältnis des Steuersignals bei einem Pegel 612, 622, welcher den entsprechenden hiermit angesteuerten Halbleiterschalter 210, 340 in einen leitenden Zustand schaltet, zur Gesamtdauer der Periode T_{PWM} des Signals verstanden. Je größer die Pulsweite 615, 625 der Steuersignale ist, desto größer sind die Zeiträume, in denen in die Erregerwicklung 460 Strom eingespeist werden kann.

In Fig. 2 sind fünf Graphen 610-650 untereinander schematisch dargestellt, die jeweils aufgetragen gegen die Zeit 601 in Einheiten der Periode T_{PWM} des pulsweitenmodulierten Signals angegeben sind. Die oberen beiden Graphen 610, 620 geben das pulsweitenmodulierte Steuersignal 611 bzw. 621 zum Ansteuern des einen der Halbleiter 210, T1 bzw. des einen weiteren der Halbleiter 340, T4 an. Aufgetragen ist ein Pegel 612, 622 gegen die Zeit 601. Da der Halbleiterschalter 210, T1 geschlossen und leitend ist, wenn das Steuersignal 611 den Pegel 1 aufweist, und offen und sperrend ist, wenn der Pegel 0 ist, können der Graph 610 und analog der Graph 620 auch als Zustandsgraphen und die Steuersignale 611, 621 als Zustandskurven der entsprechenden Halbleiterschalter T1, 210 und T4, 340 aufgefasst werden.

Im Graph 630 ist die Erregerspannung 631 aufgetragen. In Zeitbereichen 635, in denen die beiden Steuersignale den Pegel 1 aufweisen, fällt über der Erregerwicklung eine positive, etwa U_{DC} entsprechende Spannung ab. Im Graph 640 ist der sich ändernde Erregerstrom 641 dargestellt. Dieser steigt zeitlich in Bereichen 646, 648 steil an, wenn beide Halbleiterschalter 210, 340, T1, T4 leitend sind, und fällt in den Bereichen 647, 649, in denen nur einer der Halbleiterschalter 210, 340 in einem geschlossenen Zustand ist, etwas langsamer wieder ab. Bei einer intakten halbgesteuerten H-Brückenschaltung gibt es abwechselnde Stromänderungen des Erregerstroms 641.

Im letzten Graph 650 ist schließlich der Gesamtstrom I_{DC} 651, der durch die halbgesteuerte Halbbrücke fließt, gegenüber der Zeit 601 aufgetragen.

Bei der dargestellten Variante nach dem Stand der Technik sind die beiden Steuersignale 611, 621 um die halbe Periode T_{PWM}/2 versetzt. Dieses bietet den Vorteil, dass der Strom, der in den Zwischenkreiskondensator 500 ein- und ausgespeist wird, geringgehalten wird. Weiterhin ist die Frequenz der Stromwelligkeit des Erregerstroms 641 bei funktionierenden Halbleiterschaltern doppelt so groß wie die Schaltfrequenz der einzelnen Halbleiterschalter, was vorteilhaft für die Welligkeit des Erregerstroms ist. Außerdem verteilt sich die Verlustleistung jeweils gleichmäßig auf die Halbleiterschalter und Dioden. Neben der hier dargestellten mittenzentrierten Pulsweitenmodulation kann auch eine flankenbezogene Pulsweitenmodulation genutzt werden, bei der die Steuersignale 611, 621 ebenfalls um eine halbe Pulsweitenmodulationsperiode versetzt sind.

Die bisherige Beschreibung setzt voraus, dass beide Halbleiterschalter 210, T1; 340, T4 korrekt gemäß der Steuersignale 611, 621 schalten. Da die Erregerwicklung 460 in der Regel als Rotor einer Synchronmaschine ausgebildet ist und häufig eine große Induktivität 467 besitzt, besteht die Notwendigkeit, im Fehlerfall die Erregerwicklung 460 über einen der beiden Halbleiterschalter, entweder den einen der Halbleiterschalter 210, T1 oder den weiteren der Halbleiterschalter 340, T4, kurzzuschließen. Bedingt durch die Stromrichtung leitet die jeweilige Diode 230 bzw. 320 des anderen Brückenzweigs 200, 300. Erfolgt der Kurzschluss nicht, würde die Energie aus der großen Induktivität der Erregerwicklung des Rotors in den Zwischenkreis des Inverters fließen. Falls in diesem Rückspeisefall relativ zeitgleich, einschließlich kurz vor oder kurz nach dem Kurzschluss, die Batterieschütze geöffnet werden und somit der Umrichter nicht mehr mit der Traktionsnetzbatterie verbunden ist, reicht in der Regel die Kapazität üblicher Zwischenkreiskondensatoren 500 nicht aus, um eine Überspannung mit einer Zerstörung eines Hauptinverters und/oder der hier beschriebenen H-Brückenschaltung sowie gegebenenfalls anderer HV-Komponenten zu verhindern. Daher ist es sinnvoll vorab festzustellen, wenn einer der Halbleiterschalter defekt ist.

Für den Fehlerfall, dass einer der beiden Halbleiterschalter trotz Ansteuerung dauerhaft im offenen Zustand verbleibt, wird der Erregerstrom I_{exc} innerhalb einer kurzen Zeitspanne von in der Regel einigen 100 ms auf 0 absinken. Sollten beide Schalter dauerhaft eingeschaltet sein, liegt die Versorgungsspannung U_{DC} als Spannung der Erregerwicklung U_{exc} dauerhaft an, sodass der Strom durch die Erregerwicklung stark ansteigt. Eine Überstromerkennung kann diesen Fehler zuverlässig detektieren und die Versorgungsspannung abschalten. Schwieriger und kritisch ist der Fall, bei dem einer der beiden Halbleiterschalter 210, 340 nicht mehr schaltet und in einem dauerhaft leitenden Zustand verbleibt und defekt ist, während der andere Halbleiterschalter noch normal schaltet. Eine Ursache für einen solchen Defekt kann in der Ansteuerschaltung liegen oder auch ein Defekt eines der Halbleiterschalter 210, 340 selbst sein.

Aus der DE 10 2012 219 243 A1 ist ein Verfahren zum Ermitteln von Fehlerzuständen einer Halbbrückenschaltung mit zwei in Reihe geschalteten Halbleiterschaltern bekannt. Hierbei werden Ist- und Soll-Zustände der Halbleiterschalter ermittelt und miteinander verglichen.

Der Erfindung liegt die Aufgabe zugrunde, ein Verfahren und eine Vorrichtung sowie ein Computerprogrammprodukt anzugeben, mit denen auf einfachere Weise eine Erkennung eines einzelnen defekten Halbleiterschalters, der dauerhaft leitend defekt ist, in einer halbgesteuerten H-Brückenschaltung zum Stellen des Erregerstroms für eine fremderregte Synchronmaschine möglich ist.

Die Aufgabe wird erfindungsgemäß durch ein Verfahren mit den Merkmalen des Patentanspruchs 1 und durch eine Steuervorrichtung mit den Merkmalen des Patentanspruchs 10 sowie durch ein Computerprogrammprodukt mit den Merkmalen des Patentanspruchs 12 gelöst. Vorteilhafte Ausgestaltungen ergeben sich aus den Unteransprüchen.

Der Erfindung liegt die Idee zugrunde, dass beim Auftreten einer Freilaufphase, in der beide Halbleiterschalter T1, T4 der halbgesteuerten Halbrücke in einem offenen, nichtleitenden Zustand sind, während die Erregerwicklung bestromt ist, Strom über die Dioden in den Zwischenkreis fließt. Eine Strommesseinrichtung, die den durch die gesamte halbgesteuerte Halbrücke fließenden Gesamtstrom misst, erfasst dann in der Freilaufphase einen negativen Strom. Ist einer der beiden Halbleiterschalter T1, T4 der halbgesteuerten Halbrücke dauerhaft leitend defekt, so tritt dieser negative Strom während der Freilaufphase nicht auf. Um diese Erkenntnis auszunutzen, wird während der Stromregelung des Erregerstroms das durch die Pulse der Steuersignale erzeugte Steuersignalmuster verändert, sodass für mindestens eine zeitlich begrenzte Prüfzeitspanne ein Prüfschaltzustand entsteht, in dem der eine der Halbleiterschalter T1 und der eine weitere der Halbleiterschalter T4 zeitgleich geöffnet sind. Während dieser Prüfzeitspanne wird ein durch die gesamte halbgesteuerte H-Brückenschaltung fließender Strom ermittelt, der als Prüfstrom bezeichnet wird, um anzudeuten, dass dieser während einer nominellen Freilaufphase der halbgesteuerten H-Brückenschaltung erfasst ist. Der Prüfstrom wird daraufhin ausgewertet, ob dieser negativ ist. Ist dieses nicht der Fall, d.h. tritt kein negativer Prüfstrom auf, so ist davon auszugehen, dass einer der beiden Halbleiterschalter dauerhaft leitend defekt ist, oder nicht mehr in den nichtleitenden Zustand steuerbar geschaltet werden kann, weil die Steuerschaltung ein nicht korrektes Schaltsignal erzeugt. In diesem Fall wird ein Fehlersignal erzeugt und ausgegeben, das anzeigt, dass sich einer der beiden Halbleiterschalter in einem dauerhaft leitenden Zustand befindet.

Insbesondere wird ein Verfahren zum Erkennen eines einzelnen dauerhaft leitenden defekten Halbleiterschalters der Halbleiterschalter einer halbgesteuerten H-Brückenschaltung zum Stellen eines Erregerstroms einer fremderregten Synchronmaschine geschaffen, wobei die halbgesteuerte H-Brücke einen Brückenzweig mit einem der Halbleiterschalter T1 und einer in Reihe in Sperrrichtung geschalteten Diode D3 und einen weiteren Brückenzweig umfassend eine weitere Diode D2 in Sperrrichtung in Reihe mit einem weiteren der Halbleiterschalter T4 sowie einen Lastzweig umfassend eine Erregerwicklung der fremderregten Synchronmaschine, wobei der Lastzweig einen Verbindungspunkt von dem einen der Halbleiterschalter T1 und der Diode D3 in dem einen Brückenzweig und mit einem weiteren Verbindungspunkt zwischen der weiteren Diode D2 und dem weiteren der Halbleiterschalter T4 im weiteren Brückenzweig verbindet, und wobei in dem Lastzweig eine Strommesseinrichtung zum Messen des aktuellen Erregerstroms angeordnet ist;
und wobei mit der halbgesteuerten H-Brückenschaltung eine Gesamtstrommesseinrichtung zum Messen des gesamten durch die H-Brückenschaltung fließenden Gesamtstroms I_{DC} verbunden ist;
wobei die halbgesteuerte H-Brückenschaltung mit einer Steuereinrichtung gekoppelt ist, die eine Erregerstromregelung umfasst, welche zwei gleichfrequente, um eine halbe Periode phasenversetzte pulsweitenmodulierte Steuersignale zum Ansteuern des einen der Halbleiterschalter T1 und des weiteren der Halbleiterschalter T4 erzeugt, sodass der durch den Lastzweig fließende Erregerstrom über die Pulsweitenmodulation der Steuersignale gemäß einer Anforderung regelbar ist, wobei ein Tastverhältnis im Normalbetrieb auf einen Bereich von 50 % bis 100 % eingeschränkt ist, wobei das Tastverhältnis ein Verhältnis der zeitlichen Pulsbreite eines Signalpegels, der den entsprechend angesteuerten der Halbleiterschalter in einen leitenden Zustand versetzt, zur Periode des Steuersignals angibt, und wobei der Erregerstrom von der Erregerstromregelung als Rückkopplungssignal verwendet wird,
wobei das Verfahren die Schritte umfasst:
   a) Verändern des Steuersignalmusters, sodass für mindestens eine zeitlich begrenzte Prüfzeitspanne ein Prüfschaltzustand entsteht, in dem der eine der Halbleiterschalter T1 und der eine weitere der Halbleiterschalter T4 zeitgleich offen sind,
   b) Messen des durch die halbgesteuerte H-Brückenschaltung fließenden Gesamtstroms I_{DC} als Prüfstrom während der Prüfzeitspanne,
   c) Auswerten, ob der während der mindestens einen Prüfzeitspanne gemessenen Prüfstrom negativ ist,
   d) Erzeugen und Ausgeben eines Fehlersignals, wenn die Auswertung ergeben hat, dass der während der mindestens einen Prüfzeitspanne gemessenen Prüfstrom nicht negativ ist.

Auf einfache Weise kann zuverlässig ein Defekt eines der beiden Halbleiterschalter detektiert werden, bei dem dieser defekte Halbleiterschalter in einem dauerhaft leitenden Zustand verbleibt.

Die Prüfzeitspane ist jener Zeitraum, in dem nominell gemäß der nominellen Steuersignale eine Freilaufphase entsteht, wenn die Steuerschaltung korrekte Steuersignale erzeugt und beide Halbleiterschalter T1, T4 korrekt schalten.

Als Normalbetrieb wird eine Betriebszustand angesehen, in dem keine Veränderung eines der Steuersignale für einen der beiden Halbleiterschalter vorgenommen wird, um eine Prüfung auf ein Vorliegen eines Defekts eines der beiden Halbleiterschalter auszuführen. In dem Normalbetrieb werden somit die beiden Halbleiterschalter, der eine der beiden Halbleiterschalter T1 und der eine weitere der Halbleiterschalter T4, jeweils zeitversetzt gesteuert durch die zwei gleichfrequenten, um eine halbe Periode phasenversetzten pulsweitenmodulierten Steuersignalen, deren Tastverhältnis jeweils zwischen 50% und 100% liegt, abwechselnd geöffnet und geschlossen. Hierbei wird jeder der beiden Halbleiterschalter während einer Phase einmal geöffnet und einmal geschlossen. Es wird im Normalbetrieb, in dem keiner der beiden Halbleiterschalter defekt ist, keine Freilaufphase herbeigeführt. Im Normalbetrieb werden die beiden Halbeiterschalter mit zueinander identischen, jedoch um eine halbe Periode gegeneinander versetzten pulsweitenmodulierten Steuersignale angesteuert, die ein Tastverhältnis zwischen 50% und 100% aufweisen.

Auch wenn das Herbeiführen von Freilaufphasen zum Prüfen auf einen möglicherweise vorliegenden Defekt eines der beiden Halbleiterschalter regelmäßig während einer Nutzung der halbgesteuerten H-Brückenschaltung vorgenommen wird, gehört dieses Herbeiführen der Freilaufphasen nicht zum Normalbetreib. Der Betriebszustand, in dem gezielt über die Steuersignale ein Schaltzustand der beiden Halbleiterschalter herbeigeführt werden soll oder herbeigeführt ist, in dem die beiden Hableiterschalter beide zeitgleich geöffnet sind, wird als Prüfschaltzustand bezeichnet.

Ferner wird eine Steuervorrichtung mit Detektionseinrichtung zum Erkennen eines einzelnen dauerhaft leitenden defekten Halbleiterschalters einer halbgesteuerten H-Brückenschaltung zum Stellen eines Erregerstroms einer fremderregten Synchronmaschine vorgeschlagen, wobei die halbgesteuerte H-Brücke einen Brückenzweig mit einem der Halbleiterschalter T1 und einer in Reihe in Sperrrichtung geschalteten Diode D3 und einen weiteren Brückenzweig umfassend eine weitere Diode D2 in Sperrrichtung in Reihe mit einem weiteren der Halbleiterschalter T4 sowie einen Lastzweig umfassend eine Erregerwicklung der fremderregten Synchronmaschine, wobei der Lastzweig einen Verbindungspunkt von dem einen der Halbleiterschalter T1 und der Diode D3 in dem einen Brückenzweig und mit einem weiteren Verbindungspunkt zwischen der weiteren Diode D2 und dem weiteren der Halbleiterschalter T4 im weiteren Brückenzweig verbindet, und wobei in dem Lastzweig eine Strommesseinrichtung zum Messen des aktuellen Erregerstroms angeordnet ist; und wobei mit der halbgesteuerten H-Brückenschaltung eine Gesamtstrommesseinrichtung zum Messen des gesamten durch die H-Brückenschaltung fließenden Gesamtstroms I_{DC} verbunden ist; wobei die Steuereinrichtung eine Erregerstromregelung umfasst, welche ausgebildet ist, zwei gleichfrequente, um eine halbe Periode phasenversetzte pulsweitenmodulierte Steuersignale zum Ansteuern des einen der Halbleiterschalter T1 und des weiteren der Halbleiterschalter T4 zu erzeugen, sodass der durch den Lastzweig fließende Erregerstrom über die Pulsweitenmodulation der Steuersignale gemäß einer Anforderung regelbar ist, wobei ein Tastverhältnis im Normalbetrieb auf einen Bereich von 50% bis 100% eingeschränkt ist, wobei das Tastverhältnis ein Verhältnis einer zeitlichen Pulsbreite des Signalpegels, der den entsprechend angesteuerten der Halbleiterschalter in einen leitenden Zustand versetzt, zur Periode des Steuersignals angibt, und wobei der Erregerstrom von der Erregerstromregelung als Rückkopplungssignal verwendet wird, wobei die Detektionseinrichtung ausgebildet ist, ein durch die Steuersignale erzeugtes Steuersignalmuster zu verändern, sodass für mindestens eine zeitlich begrenzte Prüfzeitspanne ein Prüfschaltzustand entsteht, in dem der eine der Halbleiterschalter T1 und der eine weitere der Halbleiterschalter T4 zeitgleich offen sind; einen während der Prüfzeitspanne gemessenen durch die halbgesteuerte H-Brückenschaltung fließenden Gesamtstrom I_{DC} als Prüfstrom zu erfassen; auszuwerten, ob der erfasste während der mindestens einen Prüfzeitspanne gemessene Prüfstrom negativ ist; und ein Fehlersignal zu erzeugen und auszugeben, wenn die Auswertung ergeben hat, dass zumindest der während der mindestens einen Prüfzeitspanne gemessene Prüfstrom nicht negativ ist.

Bei einer Ausführungsform ist vorgesehen, dass der Prüfstrom nur als negativ angesehen wird, wenn die absolute Stromstärke einen Schwellenwert erreicht oder überschritten hat. Hierdurch kann die Robustheit und Zuverlässigkeit des Verfahrens gesteigert werden.

Die Detektionseinrichtung umfasst vorzugsweise einen Prozessor, auf dem ein Programmcode ausführbar ist, der im Zusammenwirken mit der oben beschriebenen Vorrichtung das Detektionsverfahren ausführt.

Die Erfindung kann in einem Programmcode umgesetzt sein, welcher auf einem Prozessor einer Steuervorrichtung zum Stellen eines Erregerstroms einer fremderregten Synchronmaschine ausgeführt wird und im Zusammenwirken der Steuervorrichtung mit einer halbgesteuerten H-Brückenschaltung, wie oben angegeben, und einer hiermit verbundenen Gesamtstrommesseinrichtung das oben angegebene Verfahren ausführt.

Bei einer bevorzugten Ausführungsform werden die Schritte a) bis c) iterativ ausgeführt. So kann jederzeit ein Ausfall zuverlässig detektiert werden.

Ein Iterationsintervall für die Iteration ist vorzugsweise so gewählt, dass dieses kürzer ist als eine Zeitspanne, für die eine Kapazität im Zwischenkreis den im Falle eines Defekts zurückfließenden Strom aus der Erregerwicklung aufnehmen kann, ohne dass Schäden entstehen.

Andere Ausführungsformen können das Iterationsintervall größer wählen. Ziel bleibt es dann, unerkannte Mehrfachfehler frühzeitig zu erkennen.

Das Verändern des Steuersignalmusters, sodass für mindestens eine zeitlich begrenzte Prüfzeitspanne ein Prüfschaltzustand entsteht, in dem der eine der Halbleiterschalter T1 und der eine weitere der Halbleiterschalter T4 zeitgleich (nominell) offen sind, wird auch synonym hier als das Herbeiführen einer zeitlich begrenzten Prüfzeitspanne bezeichnet. Dies bedeutet, dass eines der beiden Steuersignale für eine begrenzte Zeitspanne oder beide der Steuersignale für eine begrenzte Zeitspanne, die in der Regel in der Größenordnung einer Periode der Steuersignale liegt, verändert wird oder werden. Ein Abschalten der beiden Steuersignale oder Beenden der geregelten Erzeugung des Erregerstroms werden nicht als Herbeiführen eines Prüfschaltzustands oder einer zeitlich begrenzten Prüfzeitspanne angesehen.

In der Regel wird nur eines der beiden Steuersignale verändert, um ein zeitlich begrenztes Prüfzeitintervall, d. h. den Prüfschaltzustand, herbeizuführen. Vorzugsweise wird nur einer der Steuerpulse des einen der Steuersignale verändert.

Es sind jedoch auch Ausführungsformen möglich, bei denen beide Steuersignale für eine begrenzte Zeitspanne verändert werden, deren Dauer ebenfalls vorzugsweise in der Größenordnung von einer oder zwei Periodendauern der Steuersignale liegt, um eine Prüfzeitspanne mit dem Prüfschaltzustand herbeizuführen.

Eine Ausführungsform sieht somit vor, dass zum Herbeiführen des Prüfschaltzustands, vorzugsweise in ihrer entsprechenden Pulsfolge, jeweils einzelne, sich zeitlich mit einem Steuerpuls des anderen der Steuersignale überlappende Steuerpulse in beiden Steuersignalen verändert, beispielsweise unterdrückt, werden. Es werden somit ein nomineller Puls des einen Steuersignals S1 und ein nomineller Puls des weiteren Steuersignals S4, die sich zeitlich überlappen, verändert, beispielsweise unterdrückt.

Bei einer bevorzugten Ausführungsform ist vorgesehen, dass zum Herbeiführen des Prüfschaltzustands einer der Steuerpulse, die einen der Halbleiterschalter T1, T4 (210, 340) in den leitenden Zustand versetzen, in einem der Steuersignale unterdrückt wird. Diese Vorgehensweise führt auch bei großen Tastverhältnissen zu einem zuverlässigen Herbeiführen des Prüfschaltzustands. Das andere Steuersignal wird gegenüber der nominellen Vorgabe nicht verändert.

Bei einer Ausführungsform ist vorgesehen, dass zum Herbeiführen des Prüfschaltzustands einer der Steuerpulse in einem der Steuersignale zeitlich verzögert wird. Die Verzögerung erfolgt gegenüber der nominellen Position des entsprechenden Pulses. Dieses Vorgehen kann bis zu einem Tastverhältnis von 75 % ausgeführt werden. Bei höheren Tastverhältnissen kommt es ansonsten immer zu einer Überlappung der Pulse. Vorteilhaft an dieser Vorgehensweise ist, dass die Spannung-Zeit-Fläche insgesamt konstant bleibt und somit die Detektion keinen Einfluss auf den gestellten Strom in der Erregerwicklung hat.

Bei einer Ausführungsform kann vorgesehen sein, dass für mindestens drei zeitlich unmittelbar aufeinanderfolgende Steuersignalperioden das nominelle Tastverhältnis auf unter 75 % begrenzt wird und eines der Steuersignale während dieser Begrenzung des Tastverhältnisses verändert wird, um den Prüfschaltzustand herbeizuführen. Es versteht sich für den Fachmann, dass die Veränderung nicht während der gesamten Dauer der Begrenzung vorgenommen wird, sondern nur in den durch die Begrenzung vorgegeben Zeitraum fällt. So kann in jedem Fall eine zuverlässige Detektion eines dauerhaft leitend defekten Halbleiterschalters ausgeführt werden. Hierdurch wird die Möglichkeit geschaffen, den Prüfschaltzustand durch Verschieben eines der Steuerpulse in einem der Steuersignale herbeizuführen.

Bei einer Ausführungsform ist vorgesehen, dass zum Herbeiführen des Prüfschaltzustands ein zeitlicher Abschnitt des nominellen Pulses ausgetastet wird, vorzugsweise bei mittenzentrieten Pulsen in der zeitlichen Mitte. Diese Vorgehensweise führt immer zu einer zuverlässigen Messung auch bei hohen Tastverhältnissen. Der Einfluss auf den gestellten Strom ist geringer als beim Unterdrücken ganzer Steuerpulse.

Bei einer Ausführungsform ist vorgesehen, dass für mindestens einen Steuerpuls bei einem der Steuersignale das Tastverhältnis erhöht wird, d.h. dieser Steuerpuls verlängert wird, um den Einfluss des Herbeiführens des Prüfschaltzustands auf den im Lastkreis fließenden Strom i_{exc} zu kompensieren. Beim teilweisen Austasten eines Steuerpulses kann das Tastverhältnis dieses teilweise ausgetasteten Steuerpulses (bei Vernachlässigung der teilweisen Austastung) verlängert werden, sodass bei Berücksichtigung der teilweisen Austastung die Überlappung mit dem Steuerpuls des anderen Steuersignals der Überlappung gleicht, die bei nicht veränderten Steuersignalen auftritt.

Eine Ausgabe des Fehlersignals kann über eine Ausgabeeinheit, beispielsweise eine Kontrollleuchte, oder als elektrisches oder elektronisches Signal erfolgen, das beispielsweise von anderen Steuergeräten des Kraftfahrzeugs verarbeitet wird, in dem die fremderregte Synchronmaschine genutzt wird.

Um einzelne Fehlmessungen auszuschließen, ist bei einer Ausführungsform vorgesehen, dass das Fehlersignal nur ausgegeben wird, wenn eine Anzahl von vorgegebenen,
aufeinanderfolgenden Auswertungen für Prüfzeitspannen ergeben hat, dass der Prüfstrom nicht negativ ist.

Um dennoch eine hohe Zuverlässigkeit und schnelle Erkennung zu gewährleisten, ist bei einer Ausführungsform vorgesehen, dass das Iterationsintervall zwischen dem Herbeiführen von aufeinanderfolgenden Prüfschaltzuständen verringert wird, sobald die Auswertung, für die mindestens eine Prüfzeitspanne ergeben hat, dass der Prüfstrom nicht negativ ist.

Eine Kenntnis eines fehlerhaften, dauerhaft geschlossenen Halbleiterschalters ist insbesondere für den Fall vorteilhaft, dass die Erregerwicklung im Fehlerfall kurzgeschlossen werden muss. In einem solchen Fall ist es unbedingt zu vermeiden, den intakten Halbleiterschalter zu schließen, um diesen Kurzschluss herzustellen.

Der Prüfzustand, der den Betreib der halbgesteuerten H-Brückenschaltung im Normalbetriebszustand wiederkehrend unterbricht, kann, wie beschrieben, auf unterschiedliche Weise herbeigeführt werden. Das Verfahren zum Erkennen eines einzelnen dauerhaft leitenden defekten Halbleiterschalters kann somit die verschiedenen Möglichkeiten gemeinsam zeitversetzt nutzen, um den Prüfschaltzustand herzustellen Hierbei sind auch Ausführungsformen möglich, die zwischen zwei Normalbetriebszuständen Prüfschaltzustand mehrfach herbeiführen. Dieser kann hierbei jeweils auf unterschiedliche oder auf identische Weise herbeigeführt werden. D.h. das oder die Steuersignale können unterschiedlich oder identisch variiert werden. Der Prüfzustand kann auch auf unterschiedliche Weise herbeigeführt werden, wenn zwischen dem aufeinanderfolgenden Herbeiführen des Prüfschaltzustands wieder in den Normalbetriebszustand gewechselt wird. Beliebige Kombinationen der unterschiedlichen Variationsmöglichkeiten der Veränderung der Steuersingale sind möglich. Das Herbeiführen des Prüfbetriebszustand auf unterschiedliche Weise auszuführen, steigert die Detektionszuverlässigkeit eines einzelnen dauerhaft leitenden defekten Halbleiterschalters der Halbleiterschalter einer halbgesteuerten H-Brückenschaltung.

Nachfolgend wird die Erfindung unter Bezugnahme auf eine Zeichnung näher erläutert. Hierbei zeigen:
- Fig. 1: eine schematische Darstellung einer halbgesteuerten H-Brückenschaltung zum Erzeugen eines Erregerstroms;
- Fig. 2: unterschiedliche Graphen, aufgetragen gegen die Zeit in Einheiten der Zeit pro Pulsweitenperiode, wobei die Ansteuersignale für die Halbleiterschalter, eine über der Erregerspule abfallende Spannung, eine Variation des Erregerstroms sowie der durch die gesamte Schaltung fließende Gesamtstrom I_{DC} jeweils grafisch dargestellt sind;
- Fig. 3: vergleichbare Graphen zu denen der Fig. 2 für den Fall, dass einer der Halbleiterschalter dauerhaft leitend defekt ist;
- Fig. 4: vergleichbare Graphen zu denen der Fig. 2 und 3 für den Fall, dass beide Halbleiterschalter intakt sind und einer der Steuerpulse für einen der Halbleiterschalter unterdrückt ist;
- Fig. 5: vergleichbare Graphen zu denen der Fig. 2 und 3 für den Fall, dass beide Halbleiterschalter intakt sind und einer der Steuerpulse für einen der Halbleiterschalter teilweise ausgetastet ist;
- Fig. 6: vergleichbare Graphen zu denen der Fig. 2 und 3 für den Fall, dass beide Halbleiterschalter intakt sind und einer der Steuerpulse für einen der Halbleiterschalter zeitlich gegenüber seiner nominellen Position verschoben ist;
- Fig. 7: eine schematische Ansicht eines Kraftfahrzeugs mit einer fremderregten Synchronmaschine, die mittels einer halbgesteuerten H-Brückenschaltung über eine Steuereinrichtung angesteuert wird, welche eine Detektionseinrichtung zum Erkennen eines dauerhaft leitend defekten Halbleiterschalters aufweist; und
- Fig. 8: eine schematische Darstellung eines Flussdiagramms eines Verfahrens zum Erkennen eines dauerhaft leitend defekten Halbleiterschalters.

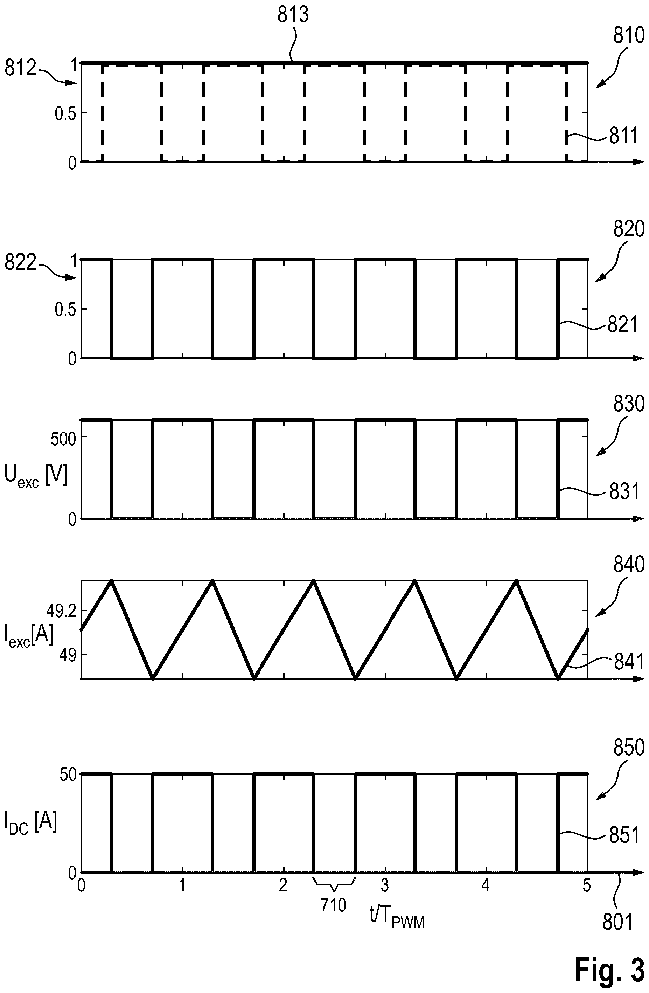

In Fig. 3 sind analog zu der oben bereits beschriebenen Fig. 2 die Signalverläufe und ermittelten bzw. sich ergebenden Messgrößen für den Betriebsfall einer halbgesteuerten H-Brückenschaltung dargestellt, bei der einer der Halbleiterschalter, ohne Beschränkung der Allgemeinheit der eine weitere Halbleiterschalter 210, T1 gemäß Fig. 1, dauerhaft leitend defekt ist. Im Graphen 820 ist der Pegel 822 des Steuersignals 821 für den weiteren der Halbleiterschalter 340, T4 gegen die Zeit 801 in Periodenlängen des pulsweitenmodulierten Steuersignals aufgetragen. Bei einem intakten Halbleiterschalter 100 kann der Graph auch als Zustandsgraph für den weiteren der Halbleiterschalter 340, T4 aufgefasst werden. Beim Pegel 0 ist der Halbleiterschalter 340, T4 geöffnet, d.h. nichtleitend, und entsprechend beim Pegel 1 leitend und geschlossen. Der Graph 810 zeigt entsprechend das Steuersignal 811 für den einen der Halbleiterschalter 210, T1, welches gestrichelt dargestellt ist. Aufgetragen ist der Pegel 812 gegen die Zeit 801. Als durchgezogene Linie ist der Schaltzustand 813 des einen der Halbleiterschalter 210, T1 dargestellt. Dieser ist dauerhaft leitend, was dem Pegel 1 entspricht. Der dritte Graph 830 zeigt die über der Erregerspule 460 abfallende Spannung U_{exc} 831 an. Da der eine der Halbleiterschalter 210, T1 dauerhaft leitend ist und ein minimales Tastverhältnis von 50 % für das Steuersignal 811 des weiteren der Halbleiter 340, T4 vorgegeben ist, liegt die Versorgungsspannung U_{DC} für mindestens die Hälfte der Zeit an der Erregerwicklung 460 an.

Dies bewirkt, dass in der Erregerwicklung 460 ein Mindesterregerstrom I_{exc_min} fließt. Der vierte Graph 840 zeigt die Amplitudenschwankung des Erregerstroms I_{exc} 841. Eine Frequenz dieser Stromänderung ist halbiert gegenüber dem intakten Betriebszustand. Der fünfte Graph 850 stellt den Gesamtstromfluss I_{DC} 851 dar.

Da der Schaltzustand des einen der Halbleiterschalter T1 210 unabhängig von dem gestrichelt dargestellten zugehörigen Steuersignal StS_{T1} 811 ist, wird bei keiner Veränderung des Pulsmusters des ersten Steuersignals zum Herbeiführen einer Freilaufphase eine solche Freilaufphase eintreten, in der beide Halbleiterschalter T1, T4 210, 340 nichtleitend sind. Ein während der Veränderung des Pulsmusters erfasster Prüfstrom entspricht einem entsprechenden Wert des Gesamtstromflusses I_{DC} 851. Der Gesamtstromfluss ist somit zu allen Zeitpunkten größer oder gleich null.

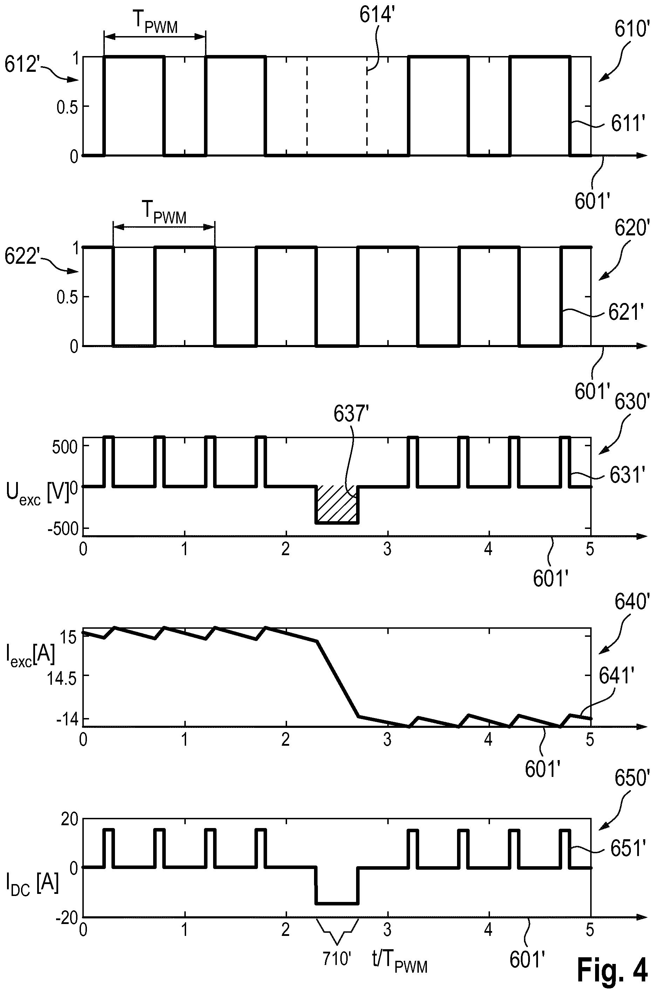

In Fig 4. Ist die Situation ähnlich zu Fig. 2 dargestellt. Beide Halbleiterschalter T1, T4 210, 340 sind intakt und schalten korrekt. Dargestellt ist die Situation, die sich ergibt, wenn eines der Steuersignale, hier ohne Beschränkung der Allgemeinheit das erste Steuersignal STS_{T1} 611', mittels einer Unterdrückung eines Steuerpulses verändert wird, um eine Detektion zum Erkennen eines dauerhaft leitend defekten Halbleiterschalters auszuführen. Die Bezugszeichen sind zur besseren Unterscheidung mit einem nachgestellten Apostroph gekennzeichnet. Das erste Steuersignal 611' und der entsprechende Schaltpegel 612' des ersten Hableiterschalters T1 210 sind entsprechend verändert, indem im dritten dargestellten Zyklus der nominelle Steuerpuls 614', der gestrichelt dargestellt ist, unterdrückt ist. Dieses bewirkt Änderungen bei der über der Erregerwicklung 460 im dem Lastzweig 400 (vergleiche Fig.1) abfallenden Spannung U_{exc} 631' im dritten Graph 630', bei dem Erregerstrom 641' im vierten Graph 640' und beim Gesamtstromfluss I_{DC} 651' im fünfen Graph 650'.

Aufgrund der Veränderung des ersten Steuersignals STS_{T1} 611' entsteht in einer zeitlich begrenzten Prüfzeitpanne 710' ein Prüfschaltzustand, bei dem beide Halbleiterschalter, der eine Halbleiterschalter T1 210 und der eine weitere Halbleiterschalter T4 340, offen und nichtleitend sind. Es entsteht eine Freilaufphase. Während dieses Zeitraums liegt an der Erregerwicklung 460 die negative Versorgungsspannung an, wie man im dritten Graph 630' und der Erregerspannung 631' erkennt.

Der Erregerstrom 641' sinkt während der Prüfzeitspanne 710' schneller im Vergleich zu den Zeiten, in denen nur einer der Halbeiterschalter T1, T4 210 340 im normalen Betrieb geöffnet und nichtleitend ist und der andere der Halbleiterschalter geschlossen und leitend ist. Dieses geht einher mit der Tatsache, dass in der Freilaufphase über die Dioden D2, D3 230, 320 Strom in den Zwischenkreis zurückfließen kann. Dieses zeigt sich in dem negativen Gesamtstromfluss 651' im fünften Graphen 650'. Ein während der Prüfzeitspanne von der Gesamtstrommesseinrichtung 180 gemessener Wert des Gesamtstroms I_{DC} 651' ist somit negativ und zeigt an, dass weder der eine der Halbleiterschalter T1 210 noch der weitere der Halbleiterschalter T4 340 dauerhaft leitend defekt sind.

Wäre der eine der Halbleiterschalter T1 210 dauerhaft leitend defekt und der andere der Halbleiterschalter T4 340 intakt, würden die Erregerspannung U_{exc} 831, der Erregerstrom I_{exc} 841 und der Gesamtstromfluss I_{DC} 851 durch den dritten bis fünften Graphen 830, 840 und 850 der der Fig. 3 repräsentiert. Der Gesamtstromfluss während der Prüfzeitspanne 710 wäre null.

Ein Integral eines Spannung-Zeit-Fensters 637' der Erregerspannung U_{exc} (schraffiert dargestellt), ist gegenüber dem Integral über die Spannung-Zeit-Fenster 637 im Normalbetrieb verkleinert, welche mit dem teilweise unterdrückten Steuerpuls bzw. dem nominellen Steuerpuls 614 korrespondieren.

Dieses kann dadurch kompensiert werden, dass einer oder mehre Pulse, die nicht verändert wurden, verlängert werden, d.h. deren Tastverhältnis gesteigert wird.

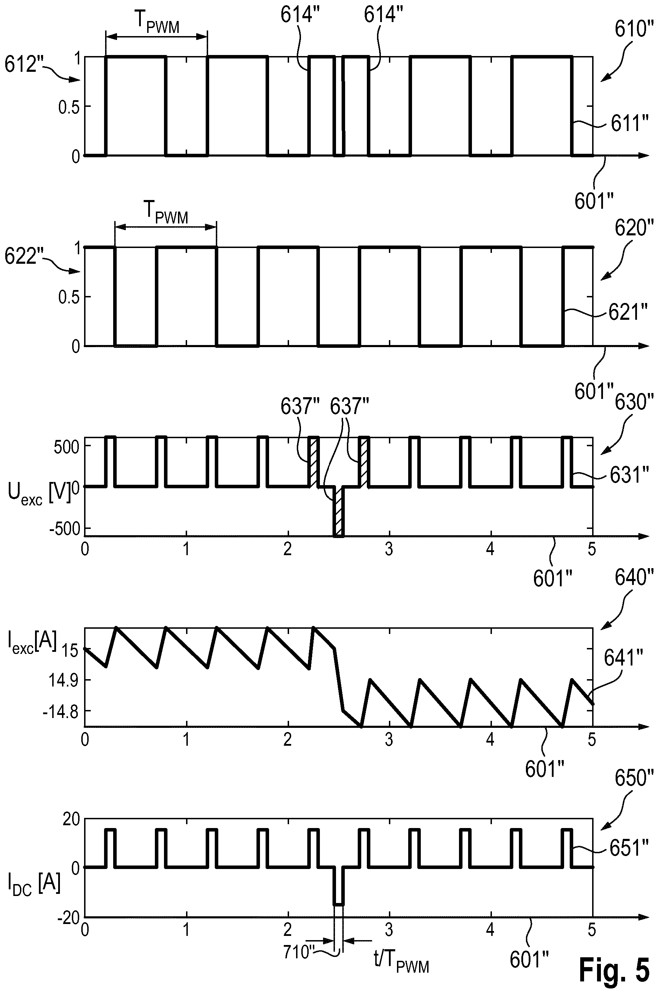

In Fig. 5 ist die entsprechende Situation dargestellt, in der das erste Steuersignal STS_{T1} 611" verändert ist, indem der nominelle Steuerpuls 614" im dritten dargestellten Zyklus nur teilweise unterdrückt wird, was auch als teilweises Austasten oder angeschnittene Pulsunterdrückung bezeichnet wird. Den Bezugszeichen sind entsprechend zwei Apostrophe nachgestellt. Die Prüfzeitspanne 710" ist kürzer als bei der Pulsunterdrückung, die in Fig. 4 dargestellt ist.

Entsprechend ist ein Einfluss auf den Erregerstrom I_{exc} 641" geringer. Ein Integral eines Spannung-Zeit-Fensters 637" der Erregerspannung (schraffiert dargestellt) ist nur geringfügig gegenüber dem Integral über die Spannung-Zeit-Fenster 637 im Normalbetrieb verkleinert, welche mit dem teilweise ausgetasteten Steuerpuls bzw. dem nominellen Steuerpuls 614" korrespondieren.

Zur Kompensation können, wie oben bereits erwähnt, das Tastverhältnis oder die Tastverhältnisse für einen oder mehrere Steuerpulse in einem oder beiden Steuersignalen erhöht werden. Bei der teilweisen Austastung, die vorzugsweis bei mittenzentrieten Pulsen in deren Mitte erfolgt, kann das nominelle Tastverhältnis des Pulses erhöht werden, sodass die teilweise Austastung in der Mitte durch den veränderten Puls selbst kompensiert wird.

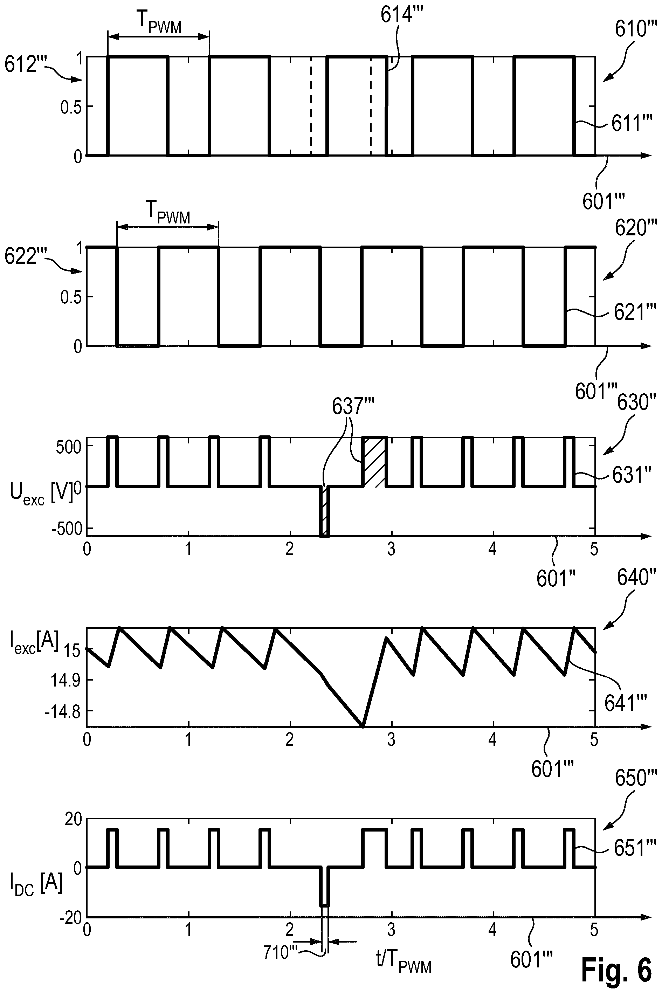

In Fig. 6 ist die Situation gezeigt, in der für die Detektion das eine Steuersignal, ohne Beschränkung der Allgemeinheit das eine Steuersignal StS_{T1} des einen der Halbleiterschalter T1 210, zeitlich verschoben wird. Bezugszeichen sind zur Unterscheidung mit drei Apostrophen gekennzeichnet. Diese Veränderung zum Herbeiführen des Prüfschaltzustands ist bis zu einem Tastverhältnis von 75% möglich. Der Vorteil ist, dass die Spannung-Zeit-Fläche 637" nahezu unverändert bleibt.

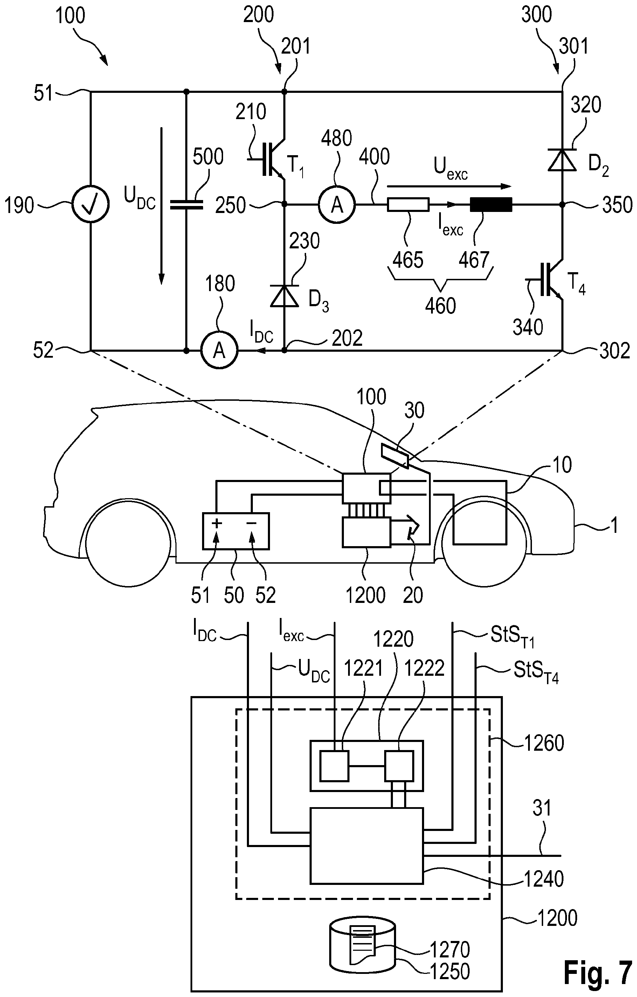

In Fig. 7 ist schematisch ein Kraftfahrzeug 1 dargestellt. Dieses weist als Antriebsmaschine eine fremderregte Synchronmaschine 10 auf. Zwei wesentliche Einflussgrößen, die den Sollerregerstrom bestimmen, sind eine aktuelle Maschinendrehzahl, welche proportional mit der Fahrgeschwindigkeit korreliert, sowie ein vom Fahrer angefordertes Drehmoment, welches hier als Anforderung 21 bezeichnet wird. Ein Erregerstrom für die in der Regel im Rotor angeordnete Erregerwicklung wird über eine halbgesteuerte H-Brückenschaltung 100 bereitgestellt, die über eine Steuereinrichtung 1200 angesteuert wird. Die elektrische Energie stammt aus einer Traktionsbatterie 50, die u. a. mit der H-Brückenschaltung 100 verbunden ist. Die Traktionsbatterie 50 weist einen Pluspol 51 und einen Minuspol 52 auf. Die Steuereinrichtung 1200 erfasst eine Anforderung 21 eines Fahrers beispielsweise über ein Fahrpedal 20. Die Steuereinrichtung 1200 umfasst eine Detektionseinrichtung 1240, welche ausgebildet ist, einen einzelnen defekten Halbleiterschalter in der halbgesteuerten H-Brückenschaltung 100 zu detektieren und ein Fehlersignal 31 auszugeben. Dieses kann beispielsweise über eine Kontrolllampe in einem Kombiinstrument oder einer beliebigen anderen Anzeigeeinrichtung 30 im Fahrzeug ausgegeben werden. Das Fehlersignal 31 kann auch als elektrisches Signal oder Funksignal ausgegeben werden, um in der Steuereinrichtung 1200 oder in anderen Steuergeräten des Kraftfahrzeugs 1 weiter verarbeitet zu werden. Diese Steuereinrichtung 1200 ist typischerweise als Bestandteil eines Pulswechselrichters, der die fremderregte Synchronmaschine ansteuert, ausgeführt.

Gleiche technische Merkmale sind mit den identischen Bezugszeichen versehen wie in den übrigen Figuren und sind hier nicht erneut ausführlich erläutert. Insbesondere die H-Brückenschaltung 100 gleicht der in Fig. 1 dargestellten H-Brückenschaltung 100.

Die Steuereinrichtung 1200 umfasst eine Erregerstromregelung 1220. Diese weist eine Reglereinheit 1221 auf, welche einen von dem erfassten Anforderungssignal abhängigen Sollstrom I_{exc_soll} ausgibt. Eine Signalerzeugungseinrichtung 1222 der Erregerstromregelung 1220 erzeugt die Steuersignale StS_{T1} und StS_{T4}. Dieses sind die pulsweitenmodulierten Steuersignale, welche um eine halbe Pulsweitenperiode gegeneinander phasenversetzt sind. Diese steuern die Halbleiterschalter T1, 210 und T4, 340. Die beiden Halbleiterschalter sind beispielsweise als IGBTs ausgebildet. Über den erfassten gemessenen Erregerstrom I_{exc}, der als Regelgröße von der Steuereinrichtung 1200 und deren Erregerstromregelung 1220 erfasst wird, kann der Erregerstrom I_{exc} gemäß dem Anforderungssignal 21 bzw. der Anforderung entsprechend geregelt werden.

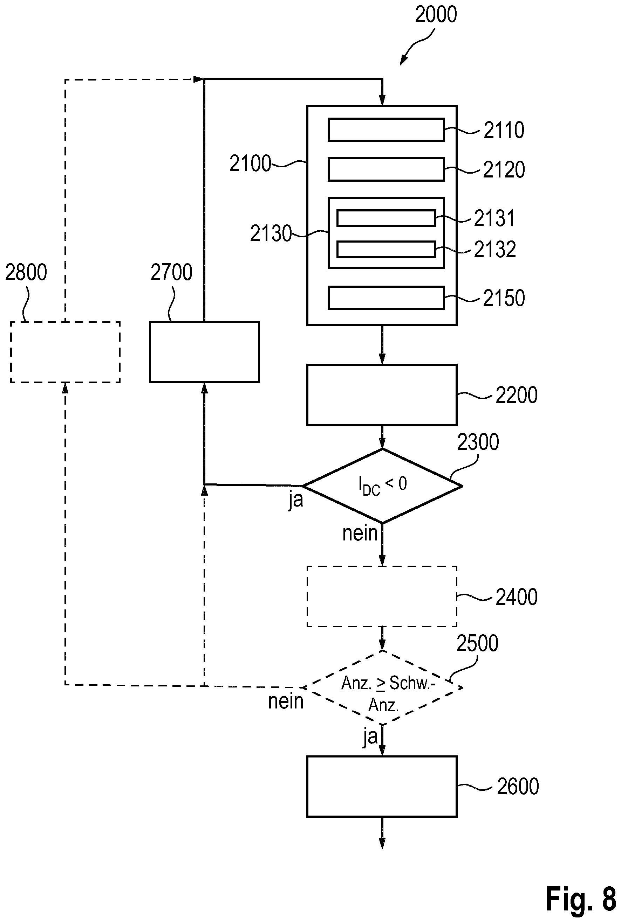

Die Detektionseinheit 1240 wird im Folgenden gemeinsam mit dem in Fig. 8 dargestellten schematischen Flussdiagramm 2000 eines Verfahrens zum Detektieren eines dauerhaft leitend defekten Halbleiterschalters in der halbgesteuerten H-Brückenschaltung 100 genauer beschrieben. Die Detektionseinrichtung 1240 verändert eines der Steuersignale StS_{T1} und StS_{T4}, um eine Freilaufphase der H-Brückenschaltung 100 herbeizuführen 2100. Dieses kann wie in der Fig. 7 angedeutet durch die Detektionseinrichtung 1240 selbst erfolgen. Alternativ kann die Detektionseinrichtung 1240 die Signalerzeugungseinrichtung 1222 entsprechend steuern, um die Veränderung gegenüber dem nominellen Pulsmuster der Steuersignale StS_{T1} und StS_{T4} herbeizuführen.

Die Veränderung kann auf unterschiedliche Weise bewirkt werden. Gemäß einer Ausführungsform wird einer der Steuerpulse eines der Steuersignale, hier ohne Beschränkung der Allgemeinheit des Steuersignals StS_{T1}, unterdrückt 2110, wie dies im Zusammenhang mit Fig. 4 erläutert ist.

Alternativ kann die Veränderung bewirkt werden, indem einer der Steuerpulse des einen Steuersignals StS_{T1} teilweise ausgetastet wird 2120, wie dies im Zusammenhang mit Fig. 5 erläutert ist.

Die Veränderung kann auch dadurch bewirkt werden, dass einer der Steuerpulse des einen Steuersignals StS_{T1} zeitlich gegenüber seiner nominellen Steuerpulsposition verschoben, vorzugsweise verzögert, wird 2130. Hierbei kann es bei einer Ausführungsform vorgesehen sein, dass beide Steuersignale für mindestens drei Zyklen auf ein Tastverhältnis von maximal 75 % begrenzt werden 2131 und einer dieser mindestens drei Pulse, vorzugsweise der mittlere Steuerpuls des einen Steuersignals StS_{T1}, zeitlich verzögert wird 2132, um den Prüfschaltzustand für die Prüfzeitspanne herbeizuführen.

Während der Prüfzeitspanne, die mit dem durch die Veränderung des einen Steuersignals StS_{T1} herbeigeführten Prüfschaltzustand korrespondiert, wird der Gesamtstrom I_{DC}, der durch die gesamte halbgesteuerte H-Brückenschaltung 100 fließt, als Prüfstrom erfasst 2200.

Anschließend wird ausgewertet 2300, ob der während der Prüfzeitspanne erfasste Prüfstrom negativ ist. Ein negativer Prüfstrom oder negativer Gesamtstrom ist ein Strom, dessen Richtung entgegengesetzt zur technischen Stromrichtung ist, die vom Pluspol zum Minuspol weist.

Ist der Prüfstrom nicht negativ, wird ein Fehlersignal ausgegeben 2600. Dieses kann beispielsweise über eine Kontrollanzeige 30 erfolgen. Das Fehlersignal kann auch von der Steuereinrichtung 1200 oder von anderen Steuereinrichtungen weiterverarbeitet werden, beispielsweise für den Fall, dass ein Kurzschließen der Erregerwicklung 460 notwendig wird.

Hat die Auswertung des Prüfstroms 2300 ergeben, dass dieser negativ ist, so wird ein Iterationsintervall abgewartet 2700, bis erneut mit dem Verändern eines Steuerpulses 2100 fortgefahren wird, um eine erneute Detektion zum Feststellen eines dauerhaft leitend defekten Halbleiterschalters auszuführen.

Bei einer Ausführungsform ist zusätzlich optional vorgesehen, dass beim Verändern der Steuersignale StS_{T1} und StS_{T4} mindestens einer der Steuerpulse angepasst wird, um den Einfluss des Herbeiführens des Prüfschaltzustands auf den Erregerstrom I_{exc} zu kompensieren 2150.

Ebenfalls alternativ kann vorgesehen sein, dass für den Fall, dass festgestellt wird, dass der Prüfstrom nicht negativ ist, zunächst ein Zähler erhöht wird, der eine Anzahl von unmittelbar aufeinanderfolgenden Auswertungen für aufeinanderfolgende Prüfzeitspannen angibt, in denen der Prüfstrom nicht negativ ist/war. Es wird somit die Anzahl der aufeinanderfolgend festgestellten nicht negativen Prüfströme ermittelt 2400.

Anschließend wird geprüft, ob diese Anzahl der Auswertungen, in denen der Prüfstrom nicht negativ war, eine vorgegebene Schwellenanzahl erreicht oder überschritten hat 2500. Ist dieses der Fall, so wird das Fehlersignal ausgegeben 2600. Vorzugsweise ist die Schwellenanzahl ein Wert größer gleich 2 und kleiner gleich 10. Ist diese Schwellenanzahl hingegen nicht erreicht, so wird kein Fehlersignal ausgegeben, sondern eine erneute Iteration der Detektion zum Erkennen eines dauerhaft leitenden Halbleiterschalters ausgeführt. Hierfür wird bei einer Ausführungsform das Iterationsintervall 2700 abgewartet. Bei einer alternativen Ausführungsform wird jedoch ein verkürztes Iterationsintervall abgewartet 2800, um eine schnelle zuverlässige Detektion eines dauerhaft leitend defekten Halbleiterschalters zu erreichen.

Es ergibt sich für den Fachmann, dass hier lediglich beispielhafte Ausführungsformen beschrieben sind. Die Merkmale können für die unterschiedlichen Varianten miteinander kombiniert werden. Beispielsweise können in unterschiedlichen Iterationszyklen unterschiedliche Veränderungen vorgenommen werden.

### Bezugszeichenliste

- 1: Kraftahrzeug
- 10: fremderregte Synchronmaschine
- 20: Fahrpedal
- 21: Fahranforderungssignal
- 30: Anzeigeeinrichtung
- 31: Fehlersignal
- 50: Traktionsbatterie
- 51: positiver Pol
- 52: Minuspol
- 100: H-Brückenschaltung
- 180: weitere Strommesseinrichtung
- 190: Spannungsmesseinrichtung
- 200: Brückenzweig
- 201: ein Ende des Brückenzweiges 200
- 202: gegenüberliegendes Ende des Brückenzweiges 200
- 210, T1: Halbleiterschalter
- 230, D3: Diode
- 250: Verbindungspunkt
- 300: weiterer Brückenzweig
- 301: ein Ende des weiteren Brückenzweiges 300
- 302: gegenüberliegendes Ende des weiteren Brückenzweiges 300
- 320, D2: weitere Diode
- 340, T4: weiterer Halbleiterschalter
- 350: Verbindungspunkt
- 400: Lastzweig
- 460: Erregerwicklung
- 465: ohmscher Wicklungswiderstand
- 467: Wicklungsinduktivität
- 480: Strommesseinrichtung
- 490: Temperatursensor
- 491: Temperatursignal
- 500: Zwischenkreiskondensator
- 601, 601', 601", 601‴: Zeit
- 610, 610', 610", 610‴: Graph
- 611, 611', 611", 611‴: Steuersignal (T1 - StS_{T1})
- 612, 612', 612", 612‴: Pegel
- 614, 614', 614", 614‴: nomineller Steuerpuls
- 620, 620', 620", 620‴: Graph
- 621, 621', 621", 621‴: Steuersignal (T4- StS_{T4}))
- 622, 622', 622", 622‴: Pegel
- 630, 630', 630", 630‴: Graph
- 631, 631', 631", 631‴: Erregerspannung
- 637, 637',, 637", 637‴: Spannungs-Zeit-Fläche
- 640, 640', 640", 640‴: Graph
- 641, 641', 641", 641‴: Erregerstrom
- 650, 650', 650", 650‴: Graph
- 651, 651', 651", 651‴: Gesamtstrom
- 710, 710', 710", 710‴: Prüfzeitspanne
- 801: Zeit
- 810: Graph
- 811: Steuersignal (StS_{T1})
- 812: Pegel
- 813: Schaltzustand (des defekten Halbleiterschalters)
- 820: Graph
- 821: Steuersignal (StS_{T4})
- 822: Pegel
- 830: Graph
- 831: Erregerspannung
- 840: Graph
- 841: Erregerstrom
- 850: Graph
- 851: Gesamtstrom
- 1200: Steuereinrichtung
- 1220: Erregerstromregelung
- 1221: Reglereinrichtung
- 1222: Signalerzeugungseinrichtung
- 1240: Detektionseinrichtung
- 1250: Speicher
- 1260: Mikroprozessor
- 1270: Programmcode
- 2000: Flussdiagramm eines Verfahrens zur Detektion eines defekten Halbleiters
- 2100: Verändern eines Steuersignals
- 2110: Unterdrücken eines Steuerpulses
- 2120: teilweises Austasten eines Steuerpulses
- 2130: Verschieben eines Steuerpulses
- 2131: Begrenzen des Tastverhältnisses
- 2132: Verzögern eines Steuerpultes
- 2150: Erhöhen des Tastverhältnisses zur Kompensation des Erregerstroms
- 2200: Erfassen des Gesamtstroms als Prüfstrom
- 2300: Auswerten des Prüfstroms
- 2400: Ermitteln der Anzahl nicht negativer Prüfströme
- 2500: ist Schwellenanzahl für Anzahl nicht negativer Prüfströme erreicht/übersch ritten
- 2600: Ausgeben eines Fehlersignals
- 2700: Iterationsintervall abwarten
- 2800: verkürztes Iterationsintervall abwarten

## Patentansprüche

1. Verfahren zum Erkennen eines einzelnen dauerhaft leitenden defekten Halbleiterschalters der Halbleiterschalter (210, 340) einer halbgesteuerten H-Brückenschaltung (100) zum Stellen eines Erregerstroms einer fremderregten Synchronmaschine, wobei die halbgesteuerte H-Brückenschaltung (100)
einen Brückenzweig (200) mit einem der Halbleiterschalter T1 (210) und einer in Reihe in Sperrrichtung geschalteten Diode D3 (230) und
einen weiteren Brückenzweig (300) umfassend eine weitere Diode D2 (320) in Sperrrichtung in Reihe mit einem weiteren der Halbleiterschalter T4 (340) sowie einen Lastzweig (400) umfassend eine Erregerwicklung (460) der fremderregten Synchronmaschine, wobei der Lastzweig (400) einen Verbindungspunkt (250) von dem einen der Halbleiterschalter T1 (210) und der Diode D3 (230) in dem einen Brückenzweig (200) und mit einem weiteren Verbindungpunkt (350) zwischen der weiteren Diode D2 (320) und dem weiteren der Halbleiterschalter T4 (340) im weiteren Brückenzweig (300) verbindet,
und wobei in dem Lastzweig (400) eine Strommesseinrichtung (480) zum Messen des aktuellen Erregerstroms angeordnet ist;
und wobei mit der halbgesteuerten H-Brückenschaltung (100) eine Gesamtstrommesseinrichtung (180) verbunden ist, die den gesamten durch die H-Brückenschaltung (100) fließenden Gesamtstrom I_{DC} misst;
wobei die halbgesteuerte H-Brückenschaltung (100) mit einer Steuereinrichtung (1200) gekoppelt ist, die eine Erregerstromregelung (1220) umfasst, welche zwei gleichfrequente, um eine halbe Periode phasenversetzte pulsweitenmodulierte Steuersignale (611, 621) zum Ansteuern des einen der Halbleiterschalter T1 (210) und des weiteren der Halbleiterschalter T4 (340) erzeugt, sodass der durch den Lastzweig (400) fließende Erregerstrom über die Pulsweitenmodulation der Steuersignale (611, 621) gemäß einer Anforderung regelbar ist, wobei ein Tastverhältnis im Normalbetrieb auf einen Bereich von 50% bis 100% eingeschränkt ist, wobei das Tastverhältnis ein Verhältnis der zeitlichen Pulsbreite eines Signalpegels (612, 622), der den entsprechend angesteuerten der Halbleiterschalter (210, 340) in einen leitenden Zustand versetzt, zur Periode des Steuersignals (611, 621) angibt, und wobei der Erregerstrom von der Erregerstromregelung (1220) als Rückkopplungssignal verwendet wird,
wobei das Verfahren die Schritte umfasst:
a) Verändern des Steuersignalmusters, sodass für mindestens eine zeitlich begrenzte Prüfzeitspanne ein Prüfschaltzustand entsteht, in dem der eine der Halbleiterschalter T1 (210) und der eine weitere der Halbleiterschalter T4 (340) zeitgleich offen sind,
b) Messen des durch die halbgesteuerte H-Brückenschaltung (100) fließenden Gesamtstroms I_{DC} als Prüfstrom während der Prüfzeitspanne,
c) Auswerten, ob der während der mindestens einen Prüfzeitspanne gemessene Prüfstrom negativ ist,
d) Erzeugen und Ausgeben eines Fehlersignals, wenn die Auswertung ergeben hat, dass der während der mindestens einen Prüfzeitspanne gemessene Prüfstrom nicht negativ ist.

2. Verfahren nach Anspruch 1, **dadurch gekennzeichnet, dass** die Schritte a) bis c) iterativ ausgeführt werden.

3. Verfahren nach einem der vorangehenden Ansprüche, **dadurch gekennzeichnet, dass** zum Herbeiführen des Prüfschaltzustands einer der Steuerpulse, die einen der Halbleiterschalter T1, T4 (210, 340) in den leitenden Zustand versetzt, in einem der Steuersignale unterdrückt wird.

4. Verfahren nach einem der vorangehenden Ansprüche, **dadurch gekennzeichnet, dass** zum Herbeiführen des Prüfschaltzustands, vorzugsweise in einer Pulsfolge, jeweils einzelne, sich zeitlich überlappende Steuerpulse in beiden Steuersignalen (611, 621) unterdrückt werden.

5. Verfahren nach einem der vorangehenden Ansprüche, **dadurch gekennzeichnet, dass** zum Herbeiführen des Prüfschaltzustands einer der Steuerpulse in einem der Steuersignale (611, 621) zeitlich verzögert und gegebenenfalls mit dem nachfolgenden Steuerpuls zusammengefasst wird.

6. Verfahren nach einem der vorangehenden Ansprüche, **dadurch gekennzeichnet, dass** zum Herbeiführen des Prüfschaltzustands ein zeitlicher Abschnitt des nominellen Steuerpulses ausgetastet wird, vorzugsweise bei mittelzentrierten Pulsen in der zeitlichen Mitte des nominellen Steuerpulses.

7. Verfahren nach einem der vorangehenden Ansprüche, **dadurch gekennzeichnet, dass** das Fehlersignal nur ausgegeben wird, wenn eine Anzahl von vorgegebenen aufeinanderfolgenden Auswertungen für Prüfzeitspannen (710) ergeben hat, dass der Prüfstrom nicht negativ ist.

8. Verfahren nach Anspruch 7, **dadurch gekennzeichnet, dass** ein Iterationsintervall zwischen dem Herbeiführen von aufeinanderfolgenden Prüfschaltzuständen verringert wird, sobald die Auswertung für die mindestens eine Prüfzeitspanne (710) ergeben hat, dass der Prüfstrom nicht negativ ist.

9. Verfahren nach einem der vorangehenden Ansprüche, **dadurch gekennzeichnet, dass** zumindest das nominelle Tastverhältnis mindestens eines Steuerpulses erhöht wird, um den Einfluss des Herbeiführens des Prüfschaltzustands auf den im Lastkreis fließenden Erregerstrom i_{exc} zu kompensieren.

10. Steuervorrichtung (1200) mit Detektionseinrichtung (1240) zum Erkennen eines einzelnen dauerhaft leitenden defekten Halbleiterschalters der Halbleiterschalter (210, 340) einer halbgesteuerten H-Brückenschaltung (100) zum Stellen eines Erregerstroms einer fremderregten Synchronmaschine, wobei die halbgesteuerte H-Brückenschaltung (100) einen Brückenzweig (200) mit einem der Halbleiterschalter T1 (210) und einer in Reihe in Sperrrichtung geschalteten Diode D3 (230) und
einen weiteren Brückenzweig (300) umfassend eine weitere Diode D2 (320) in Sperrrichtung in Reihe mit einem weiteren der Halbleiterschalter T4 (340) sowie einen Lastzweig (400) umfassend eine Erregerwicklung (460) der fremderregten Synchronmaschine, wobei der Lastzweig einen Verbindungspunkt (250) von dem einen der Halbleiterschalter T1 (210) und der Diode D3 (230) in dem einen Brückenzweig (200) und mit einem weiteren Verbindungspunkt (350) zwischen der weiteren Diode D2 (320) und dem weiteren der Halbleiterschalter T4 (340) im weiteren Brückenzweig (300) verbindet,
und wobei in dem Lastzweig (400) eine Strommesseinrichtung (480) zum Messen des aktuellen Erregerstroms angeordnet ist;
und wobei mit der halbgesteuerten H-Brückenschaltung eine Gesamtstrommesseinrichtung (180) zum Messen des gesamten durch die H-Brückenschaltung (100) fließenden Gesamtstroms I_{DC} verbunden ist;
wobei die Steuereinrichtung (1200) eine Erregerstromregelung (1220) umfasst, welche ausgebildet ist, zwei gleichfrequente, um eine halbe Periode phasenversetzte pulsweitenmodulierte Steuersignale (611, 621) zum Ansteuern des einen der Halbleiterschalter T1 (210) und des weiteren der Halbleiterschalter T4 (340) zu erzeugen, sodass der durch den Lastzweig (400) fließende Erregerstrom über die Pulsweitenmodulation der Steuersignale (611, 621) gemäß einer Anforderung regelbar ist, wobei ein Tastverhältnis im Normalbetrieb auf einen Bereich von 50 % bis 100 % eingeschränkt ist, wobei das Tastverhältnis ein Verhältnis einer zeitlichen Pulsbreite des Signalpegels (612, 622), der den entsprechend angesteuerten der Halbleiterschalter (210, 340) in einen leitenden Zustand versetzt, zur Periode des Steuersignals (611, 621) angibt, und wobei der Lastzweig (400) eine Strommesseinrichtung (480) umfasst, um den Erregerstrom zu messen, der von der Erregerstromregelung (1220) als Rückkopplungssignal verwendet wird,
**dadurch gekennzeichnet, dass**
die Detektionseinrichtung (1040) ausgebildet ist, ein durch die Steuersignale erzeugtes Steuersignalmuster zu verändern, sodass für mindestens eine zeitlich begrenzte Prüfzeitspanne ein Prüfschaltzustand entsteht, in dem der eine der Halbleiterschalter T1 (210) und der eine weitere der Halbleiterschalter T4 (340) zeitgleich offen sind;
einen während der Prüfzeitspanne gemessenen, durch die halbgesteuerte H-Brückenschaltung fließenden Gesamtstrom I_{DC} als Prüfstrom zu erfassen; auszuwerten, ob der erfasste, während der mindestens einen Prüfzeitspanne gemessene Prüfstrom negativ ist;
und ein Fehlersignal zu erzeugen und auszugeben, wenn die Auswertung ergeben hat, dass zumindest der während der mindestens einen Prüfzeitspanne gemessene Prüfstrom nicht negativ ist.

11. Steuervorrichtung (1200) nach Anspruch 10, **dadurch gekennzeichnet, dass** die Detektionseinrichtung (1240) einen programmgesteuerten Mikroprozessor sowie einen Programmspeicher mit Programmcode umfasst, wobei bei einem Ausführen des Programmcodes auf dem Prozessor die Schritte gemäß einem Verfahren nach einem der Ansprüche 1 bis 8 ausgeführt werden.

12. Computerprogrammprodukt, umfassend Programmcode, der bei einer Ausführung auf einen Mikroprozessor im Zusammenwirken mit der Steuervorrichtung (1200) nach einem der Ansprüche 10 oder 11 und der darin beschriebenen halbgesteuerten H-Brückenschaltung (100) sowie einer hiermit gekoppelten Gesamtstrommesseinrichtung (180) zum Messen des durch die beschriebene halbgesteuerte H-Brückenschaltung (100) fließenden Gesamtstroms I_{DC} das Verfahren nach einem der Ansprüche 1 bis 8 ausführt.
